# EUROPEAN PATENT SPECIFICATION

(11) **EP 3 574 577 B1**
(45) Date of publication and mention of the grant of the patent: **12.01.2022**
(21) Application number: 18705975.3
(22) Date of filing: 25.01.2018
(51) Int. Cl.: H02N 2/18, H01L 41/113

(54) **DEVICE FOR PRODUCING ELECTRICITY USING THE COMBINED ACTION OF PULSED MAGNETIC FIELDS AND OF FLUID DYNAMIC CURRENTS**
VORRICHTUNG ZUR ERZEUGUNG VON ELEKTRIZITÄT UNTER VERWENDUNG DER KOMBINIERTEN WIRKUNG GEPULSTER MAGNETISCHER FELDER UND FLUIDDYNAMISCHER STRÖME
DISPOSITIF PERMETTANT DE PRODUIRE DE L'ÉLECTRICITÉ AU MOYEN DE L'ACTION COMBINÉE DE CHAMPS MAGNÉTIQUES PULSÉS ET DE COURANTS DYNAMIQUES DE FLUIDES

(30) Priority: 26.01.2017 IT 201700008383
(43) Date of publication of application: 04.12.2019
(73) Proprietor: Explea S.r.l., 42121 Reggio Emilia (IT)
(72) Inventor: SACCARDI, Pierluigi, 42030 Vezzano Sul Crostolo (RE) (IT); CAPPELLI, Fabio Renato, 40068 San Lazzaro di Savena (BO) (IT)
(74) Representative: Mola, Edoardo
(86) International application number: PCT/IB2018/050444
(87) International publication number: WO 2018/138662

(56) References cited:
- WO-A1-2016/053370
- WO-A2-2010/151738
- GB-A- 2 464 482
- US-A1- 2011 048 133
- US-A1- 2013 119 669

## Description

The invention relates to a device for producing electricity produced by the deformation of a piezoelectric element carried by a flexible blade subject to the action of fluid dynamic currents and subjected to the action of pulsed magnetic fields.

There are known wind generators with turbines provided with blades and rotors of large sizes, which require particularly high production, installation and maintenance costs.

Moreover, these generators have the great drawback of being able to be installed only in specific and limited places, with winds of high intensity, such as hill or mountain crests, valleys or coastal areas.

There are also available on the market wind power systems equipped with piezoelectric elements for the production of electricity, but which can only function with winds of high intensity.

The US 2011/0048133 A1 and the WO 2010/151738 A disclose magnetically enhanced cantilever-type piezoelectric energy harvesting arrangements, where a piezoelectric cantilever beam is equipped with a magnet at the free end, the magnet interacting with fixed magnets to improve the bending behaviour.

Devices harvesting energy from fluid flows by means of a vibrating cantilever are known from the GB 2 464 482 A as well as from the WO 2016/053370 A (including a repellent magnet arrangement for resonant frequency tuning).

The system according to the invention as defined by the features of claim 1 intends to overcome the aforesaid problems with the use of components of limited size and with limited production costs, which can be easily assembled in modules that can be electrically connected to one another and can also be applied in places subjected to not particularly high fluid dynamic currents, such as building facades, road and rail tunnels, sound absorption barriers placed to protect residential and other areas from noise pollution.

Each device according to the invention is composed of a flexible blade to which a piezoelectric element is fixed, secured by one end with suitable means inside the frame of a modular element, while this blade has a ferromagnetic unit at the opposite end.

The two opposite faces of this ferromagnetic unit or magnet of the blade are preferably aligned and at a correct distance from magnets fixed to specific supports present inside the frame of the module.

In the absence of fluid dynamic currents the magnetic fields of the aforesaid magnets do not interact with one another, while in the presence of currents even of low intensity, as soon as the blade bends in one direction the magnet fixed thereto, moving toward one of the magnets of the fixed supports will undergo the influence of the magnetic field of this magnet, amplifying the bending of the blade, until a specific shutter is activated interrupting the mutual influence of the magnetic fields of the two adjacent magnets.

At this point, due to its elasticity, to the mechanical energy accumulated and to fluid dynamic components, the blade bends rapidly in the opposite direction, the piezoelectric element releases electricity and the magnet of the blade will interact with the fixed magnet of the second support until a further shutter associated therewith is activated, interrupting the mutual influence of the two magnetic fields.

The combined action of the magnets and of the shutters thus produces a control and amplification system of inductive type of the alternate bending of the blade and consequently of the piezoelectric element associated therewith, with considerable increase in the electricity produced even in the presence of fluid dynamic currents of low intensity.

The fixed magnets can be connected to the module in an orthogonal position with respect to the magnet of the blade and in lateral or frontal position in relation to the free end of the same blade, in this case no shutters are present as during its bending movement, the blade itself interrupts the mutual influence between the magnetic field of its magnet and the magnetic field of the adjacent magnet.

Further characteristics of the invention and the advantages deriving therefrom will be more apparent from the following description, provided with reference to the figures of the five accompanying drawings, wherein:
- Fig. 1 is a perspective view of a flexible blade of the device according to the invention, which at one end carries a piezoelectric element, and at the opposite end carries a magnet, said blade being provided with fixing means to a support, provided inside the frame of a modular element;
- Fig. 2 is a top plan view and with parts in section of the blade and of the support of the device of Fig. 1;
- Figs. 3, 4 and 5 schematically illustrate all the active components of the device, illustrated during some phases of its operation and in particular, in the resting phase of the blade, in the bending phase thereof amplified by the mutual influence of the magnetic fields of the two adjacent magnets and in the operating phase of the shutter that interrupts these fields;
- Figs. 6, 7, 8 and 9 schematically illustrate different embodiments of the device that provide for positioning of the magnets with polarity oriented differently and that produce different effects on the oscillation of the blade;
- Fig. 10 illustrates a possible embodiment of a portion of a module in which two devices according to the invention are positioned;
- Fig. 11 illustrates a variant of embodiment of the shutters that interrupt the magnetic fields of the magnets present in the device.
- Figs. 12 and 13 illustrate a variant in which the magnets fixed to the module are not aligned vertically with the magnet of the blade, but are placed laterally to the blade and in orthogonal position with respect to this magnet, respectively in the resting position and in the active position of bending of the same blade, in which the magnetic field of its magnet interacts with the magnetic field of one of the fixed magnets.
- Figs. 14 and 15 illustrate a further variant in which the magnets fixed to the module are placed in front of the free end of the blade and in orthogonal position with respect to the magnet of the same blade.

In the figures, the numeral 1 indicates a blade made of any suitable flexible and elastic material, such as polyamide materials, such as those known on the market with the trade names Nylon and Rilsan, carbon fibre, with thermosetting materials such as epoxy resins, with man-made resins such as acrylic resins and elastomers, PE, PET or the like.

Metal materials, such as stainless steel, non-magnetic harmonic steel, aluminium, brass and the like can also be used to manufacture this blade 1.

An element 2 made of piezoelectric material is associated with this blade, the element can be fixed to the outside of the same blade, or can be embedded inside the blade during the manufacture thereof.

According to a preferred, but not exclusive, embodiment of the invention, the blade 1 can be rectangular in shape with a longer side of around 100-130 mm, a shorter side of around 13 mm and a thickness ranging between 0.5 and 3 mm.

The section of this blade can be of constant type or of profiled type with variable values along all three-dimensional axes of the same blade.

The piezoelectric element 2 will be rectangular in shape, preferably with a longer side of approximately 40 mm and a shorter side of approximately 9 mm.

This blade carries, fixed at one end, a tang 3 of any suitable shape useful for fixing to a respective seat provided on a support 4 fixed inside the frame 5 of a module M, all produced with a configuration such that the blade is arranged in a position substantially orthogonal with respect to the wind flow V, with an inclination with respect to the sliding axis of the flow V that preferably ranges from 1° to 4°.

According to a construction variant, not illustrated, the blade 1 can be fixed to a support of the module so as to be arranged longitudinally with respect to the direction of the wind flow V.

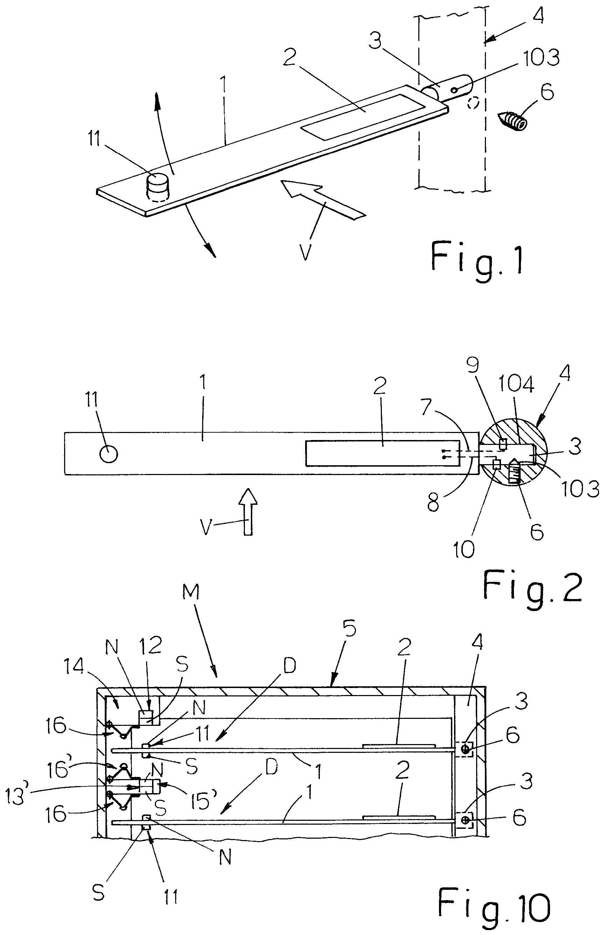

In Figs 1 and 2, the tang 3 has a cylindrical shape and is fixed inside a seat 104 of the support 4 by means of a grub screw or screw 6 whose tip engages a seat 103 provided on the same tang.

The electrodes 7 and 8 of the armature of the piezoelectric element 2 are connected to respective electric wires 9 and 10 provided in the support 4 and these connections can be external or internal, as illustrated in Fig. 2, where both the electrodes 7 and 8 and the wires 9 and 10 are embedded respectively inside the components 1 and 3 of the device and inside the support 4, all produced so as to obtain sliding electrical connections that in this case, besides offering greater protection of the electric contacts, also facilitate the assembly operation of the aforesaid components.

Each support 4 of a module M can carry a certain number of blades 1 with a mutual distance between them sufficient to ensure that the same blades can oscillate freely.

According to a variant of embodiment, the supports 4 can also be excluded and in this case the tangs 3 of the blades can be fixed inside specific seats produced directly on the frame 5.

According to a further variant, the two vertical sides of the module can each have a respective support 4 and the blades 1 can be fixed to these supports alternately, in the space inside the module.

The piezoelectric elements 2 are electrically connected to one another in series or in parallel and the total electricity value is carried outside the module to be interfaced with other energy values of any adjacent modules that form the system with electrical connections that can be external or internal by means of sliding contacts.

Each blade 1 carries, fixed to the free end thereof, a magnet 11 made with materials having ferromagnetic properties, such as Neodymium and positioned so that the opposite faces of different polarities protrude by a correct length from the opposite upper and lower surfaces of the same blade.

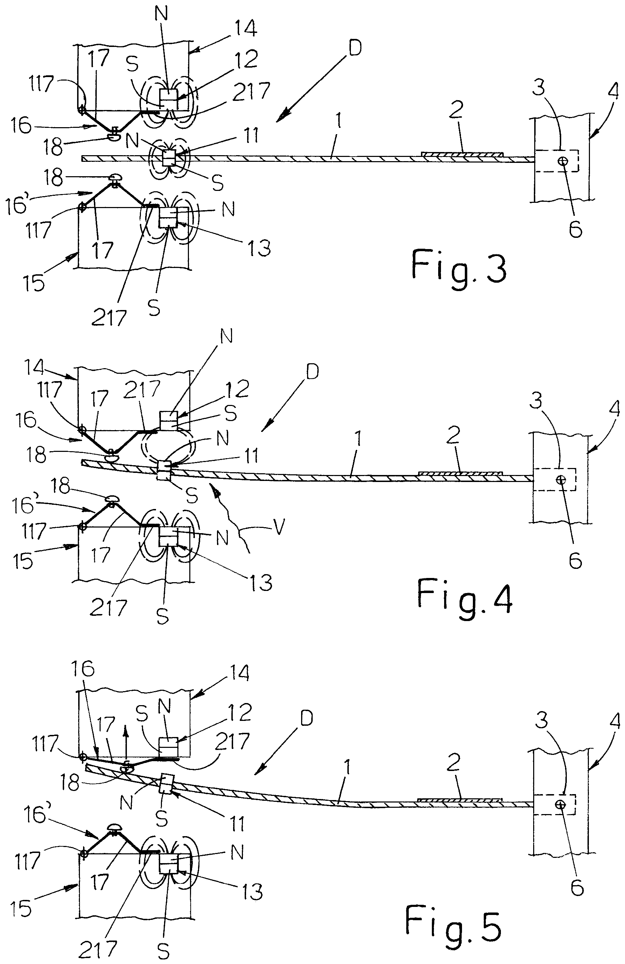

The two opposite faces of the magnet 11 of the blade are aligned at a correct distance with magnets 12 and 13 fixed to specific supports 14 and 15 present inside the frame 5 of the module M, so that in the absence of fluid dynamic currents the magnetic fields of the three magnets 11, 12 and 13 cannot mutually influence one another, as illustrated in Fig. 3.

The magnets 12 and 13 have the same electromagnetic force, while the magnet 11 of the blade preferably has an electromagnetic force lower than that of the magnets 12 and 13, or the element 11 can be made with ferrous metal material instead of ferromagnetic material, as described in more detail below.

According to a preferred embodiment, the magnets 11, 12 and 13 have a cylindrical shape with a diameter that can vary from 2 to 5 mm and with a length that can vary from 2 to 10 mm.

With particular reference to Figs. 3-5, the numerals 16 and 16' illustrate shutters identical to each other, which according to a first embodiment illustrated in these figures are produced with a flexible blade 17 produced with any suitable non-magnetizable material, which can be a plastic, such as acrylic, PET, PP, PVC and the like, or a metal such as harmonic steel, stainless steel, brass and the like.

This blade 17 of the shutters 16, 16', which has a wedge or arch shaped profile oriented in the direction of the blade 1, is connected at one end 117 to the respective support 14, 15, while the opposite end is free and has a rectilinear portion 217 that, in the idle condition, is positioned laterally to the respective magnets 12 and 13.

In the area of contact with the blade 1, the blade 17 also has an adjustment screw 18 useful to vary the activation time of the shutter and consequently also the bending and the operating frequency of the blade 1.

Both the supports 14 and 15 and the frame 5 of the modules M are produced with non-ferromagnetic materials that can made of plastic or non-ferrous metal, such as, for example, aluminium or its alloys, brass and the like.

In the embodiment illustrated in Figs. 3-5, all three magnets 11, 12 and 13 are polarized on the device D in the same direction, for example with the pole N above and with the pole S below, so that when the blade 1 bends through the action of the fluid dynamic current V, as soon as the magnetic field of 11 interferes with the magnetic field of one of the two magnets 12 and 13, the same magnetic field of 11 is attracted by one of the same magnetic fields of 12 and 13 thereby amplifying the bending of the blade 1 and the moment thereof and consequently also the deformation of the piezoelectric element 2 associated therewith.

Fig. 4 illustrates this operating phase of the device D in which the field of the magnet 12 interacts with the field of the magnet 11 rapidly attracting the blade 1 toward it, and through deformation, the piezoelectric element 2 is electrically polarized producing a potential difference on its armatures.

The blade 1 continues to bend until the shutter 16 is activated, which under the thrust of the same blade on its adjustment screw 18 extends to interrupt with its portion 217 the influence between the fields of the magnets 12 and 11 as illustrated in Fig. 5.

At this point, due to its elasticity, to the mechanical energy accumulated and to a fluid dynamic component, the blade 1 bends rapidly in the opposite direction, the piezoelectric element 2 releases electricity and the magnet 11 of the blade interacts with the fixed magnet 13 of the second support 15 until a further shutter 16' associated therewith is activated and the polarization sign of the armatures of the piezoelectric element is inverted thereby producing alternating electrical current, with repetition of the operating cycle.

Therefore, the fluid dynamic component only has the function of starting the initial phase of oscillation of the blade 1 and of facilitating oscillation of the same blade in the opposite direction when the shutters that interrupt the mutual influence of the magnetic fields are activated.

Fig. 10 illustrates a possible embodiment of a portion of a module M with two devices D according to the invention.

In this figure it is evident how a single magnet 13' can be used, between two adjacent blades 1, which will be fixed to a support 15' so that its two polarities N and S face freely on opposite walls of the same support 15' to be able to interact with the magnets 11 of the blades 1 in their bending step.

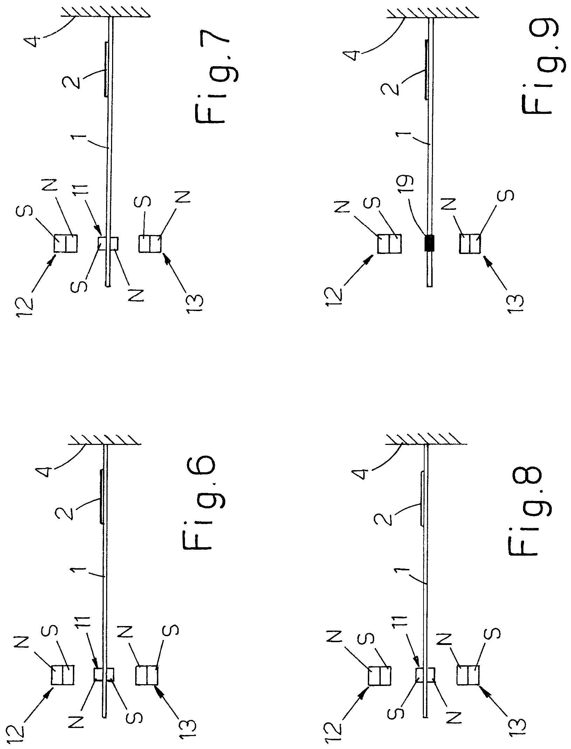

Figs. 6 to 9 schematically illustrate different embodiments of application of the magnets 11, 12 and 13 in the device D according to the invention.

In Figs. 6 and 7 both the magnet 11 of the blade 1, and the two magnets 12 and 13 fixed on the supports of the frame are positioned with the polarities oriented in the same direction so that the opposite poles of two adjacent magnets are always polarized with opposite sign, either N-S or S-N.

This embodiment is preferred as the blade 1 is subjected to a magnetic field of high intensity generated by the polarities of the magnets mutually attracted to each other, which produces significant bending of the same blade and of the piezoelectric element associated therewith, which translates into a noteworthy production of electricity.

Fig. 8 illustrates a different embodiment of the device in which the magnets are applied to the blade 1 and to the supports of the frame so that the opposite poles of two adjacent magnets are always polarized with the same sign, either N-N or S-S.

This orientation of the magnets produces a greater oscillation frequency but less bending of the blade 1, due to the fact that as soon as the magnetic fields of the three ferromagnetic elements interact they repel one another.

Fig. 9 illustrates a further embodiment of the device in which an element 19 made of simple ferrous material is mounted on the blade 1.

This solution produces a lower moment between the ends of the blade 1 as the magnetic attraction force exerted thereon is lower and therefore it is free to oscillate at a higher frequency.

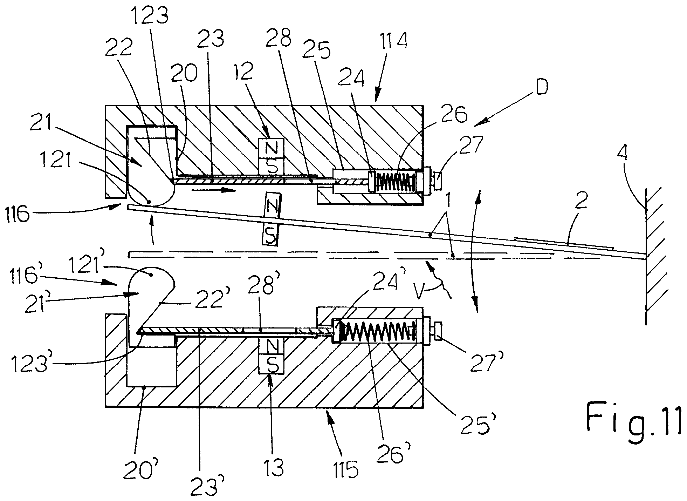

Fig. 11 illustrates a different embodiment of the shutters 116, 116' that interrupt the magnetic fields in the device D according to the invention, in which there are provided, on the supports 114, 115 fixed to the frame of the module, seats 20, 20' for respective sliders 21, 21' that can move freely but without clearance inside the same seats and that protrude outside the same seats by a correct length.

Preferably, these sliders 21, 21' have the shape of small cylinders.

The portion of these sliders that protrudes outside the seats preferably has a semi-spherical structure 121, 121' and each slider has a milled inclined profile 22, 22' that is engaged by the free end 123, 123' of a blade 23, 23' preferably with an oblique profile to mate with the profile of the respective milled inclined profile 22, 22'.

The end of the blade 23, 23' opposite the end 123, 123' has a limit stop element 24, 24' positioned inside a seat 25, 25' provided in the fixed supports 114, 115 and subject to the action of a thrust spring 26, 26', blocked inside the seat through a specific screw adjuster 27, 27' fixed to the supports 114, 115.

The blade 23, 23' also has a slot 28, 28' suitably positioned and sized to allow the passage of the magnetic fields as described below.

When the device D is at rest with its blade 1 not subject to any fluid dynamic current and the fields of the magnets 11, 12 and 13 are not interacting with one another, the shutter 116' is as illustrated in the lower part of Fig. 11, in which the spring 26' acting on the element 24' thrusts the blade 23' to extend with its end 123' that is positioned at the end of the inclined profile 22' opposite the end 121' of the slider 21' and farther away from the magnet 13.

In this resting phase of the blade 23' the slider 21' protrudes for a considerable length outside the seat 20' and the slot 28' is aligned with the magnet 13 of the support 115 so that the magnetic field of the same magnet is free to exit from said support to be able to interact with the magnetic field of the magnet 11 of the blade 1 when it bends downward, observing Fig. 11.

The top part of this figure illustrates the active closing phase of the upper shutter 116 in which the blade 1 during maximum upward bending thereof has thrust the slider 21 completely inside the seat 20 and the inclined profile 22 of the same slider has thrust the blade 23' with the related slot 28 backward so as to interrupt the magnetic field of the magnet 12 that prior to this action was interacting with the field of the magnet 11 of the blade.

At this point, due to the effect of the mechanical energy accumulated by it, the blade 1 can bend in the opposite direction, the piezoelectric element 2 releases its electricity and the magnet 11 will interact with the fixed magnet 13 also facilitated by the fluid dynamic components, until the shutter 116' is activated and the polarization sign of the armatures of the piezoelectric element is inverted, thereby producing an alternating electrical current, with a repetition of the operating cycle.

Also for this solution, adjustment means, not illustrated and easily produced by those skilled in the art, useful to vary the activation time of the shutter and consequently also the bending and the operating frequency of the blade 1 can be used.

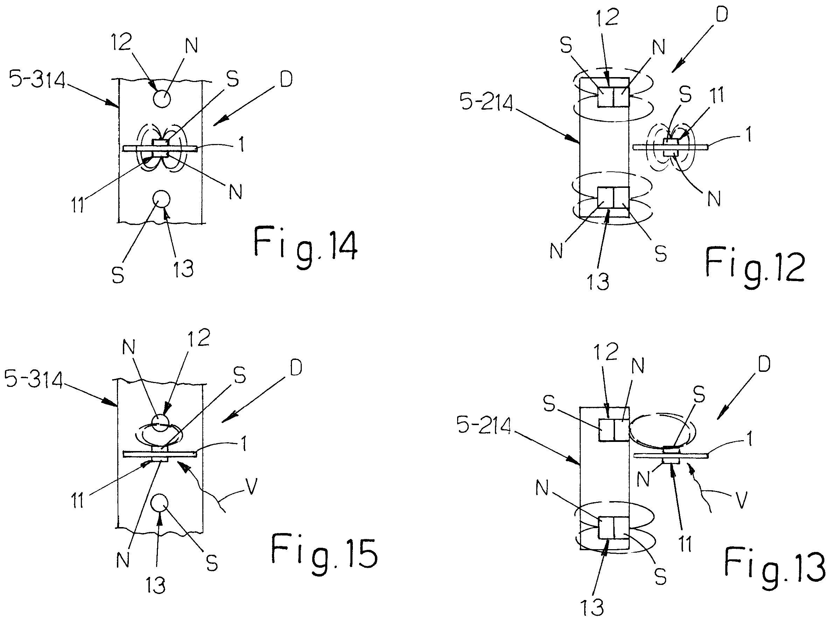

Figs. 12 and 13 illustrate a variant of the device D according to the invention, which provides for the application of the fixed magnets 12 and 13 in a lateral position with respect to the blade 1 and orthogonal with respect to the magnet 11 of the same blade.

These magnets 12 and 13 can be fixed to a support 214 present on the frame 5 or directly to the frame itself.

In Fig. 12 the device D is at rest and the magnetic fields of the magnets 11, 12 and 13 do not mutually influence one another, while when a fluid dynamic current V is activated the blade 1 bends and the magnetic field of its magnet 11 is attracted by the magnetic field of one of the two fixed magnets 12 and 13, in this case by the magnet 12, amplifying the bending of the same blade and of the piezoelectric element associated therewith, as illustrated in Fig. 13.

In this embodiment the shutters are not necessary as it is the same blade 1 that, by continuing to bend upwards, interrupts the mutual influence between the magnetic field of its magnet 11 and the magnetic field of the magnet 12.

According to a further embodiment, illustrated in Figs. 14 and 15, the fixed magnets 12 and 13 are positioned on the module in front of the free end of the blade 1 and in orthogonal position with respect to the magnet 11 of the same blade.

These magnets 12 and 13 can be fixed to a support 314 present on the frame 5 or directly to the frame itself.

Also in this case with the device D at rest the magnetic fields of the magnets 11, 12 and 13 do not influence one another, while in the presence of a fluid dynamic current V the magnetic field of the magnet 11 interacts with the field of one of the two fixed magnets 12 and 13 until the same blade, continuing to bend upwards, interrupts the mutual influence of the fields of the magnets.

In the device D according to the invention the combined action of the magnets, of the respective shutters or of the bending blade thus produces a control and amplification system of inductive type of the alternated bending of the same blade and of the piezoelectric element associated therewith, which translates into a noteworthy increase of the electricity produced with respect to a solution that uses only fluid dynamic currents to bend the blade.

Therefore, the fluid dynamic component only has the function of starting the initial phase of oscillation of the blade 1 and of facilitating the oscillation of the same blade in the opposite direction when the mutual influence of the magnetic fields between adjacent magnets is interrupted.

A given number of these devices D can be electrically connected to one another in series or in parallel and can be assembled in modules M electrically connectable to one another to produce systems of various shapes and sizes that can be applied in a variety of places, even those not normally influenced by fluid dynamic currents of high intensity, such as building facades, road and rail tunnels, sound absorption barriers placed to protect residential and other areas from noise pollution.

It is understood that numerous variants and modifications can be made to the device as described, all without departing from the scope of protection of the invention as claimed below.

## Claims

1. A device for producing electricity using the combined action of pulsed magnetic fields and of fluid dynamic currents comprising a blade (1) produced with any suitable flexible material, fixed at one end inside a frame, said blade being provided with a piezoelectric element (2) and equipped with a magnet (11) whose opposite poles are aligned at a correct distance with respective poles of further magnets (12, 13) applied to fixed supports (14, 15, 114, 115) that also carry respective shutters (16, 16', 116, 116'), all produced so that in the absence of fluid dynamic currents (V) the magnetic fields of the aforesaid three magnets do not interact with one another, while in the presence of fluid dynamic currents (V), as soon as the blade (1) bends in one direction, the magnetic field of its magnet (11), moving towards the magnetic field of one of said fixed magnets (12, 13), is subject to the influence thereof, amplifying the bending of the blade, until activation of a shutter (16, 16', 116, 116') operated by the same blade to interrupt the mutual influence of these magnetic fields by introducing a magnetic fields interrupting portion (217) at one free end of the shutter between the magnets (12, 13) which portion (217), in an idle condition, is positioned laterally to the magnets (12, 13), allowing the same blade to bend in the opposite direction both due to the accumulated mechanical energy thereof and to the presence of the fluid dynamic currents and allowing the piezoelectric element to release electricity.

2. The device according to claim 1,
**characterized in that** the magnets (12, 13) are fixed to the frame in an orthogonal position with respect to the magnet (11) of the blade (1) and in a lateral or frontal position in relation to the free end of the same blade, the same blade, during bending thereof, interrupting the mutual influence between the magnetic field of its magnet (11) and the magnetic field of the adjacent magnet (12, 13).

3. The device according to claim 1,
**characterized in that** the fixed magnets (12, 13) have a magnetic force the same as each other and preferably greater than that of the magnet (11) of the flexible blade (1).

4. The device according to claim 1,
**characterized in that** both the magnet (11) of the blade (1) and the two fixed magnets (12, 13) are installed with the polarities oriented in the same direction, so that the opposite poles of two adjacent magnets are always polarized with opposite sign (N-S) or (S-N).

5. The device according to claim 1,
**characterized in that** the magnets (11, 12 and 13) are applied to the blade (1) and to the fixed supports so that the opposite poles of two adjacent magnets are always polarized with the same sign (N-N) or (S-S).

6. The device according to claim 1, **characterized in that** an element (19) produced
with ferrous material is mounted on the blade (1).

7. The device according to claim 1,
wherein the shutters (16, 16') are produced with a flexible blade (17) made of a non-magnetizable plastic material, such as acrylics, PET, PP, PVC and the like.

8. The device according to claims 1 and 6
**characterized in that** the shutters (16, 16') are produced with blades made of a non-magnetizable metal material, such as harmonic steel, stainless steel, brass and the like.

9. The device according to one or more of the preceding claims, **characterized in that** the shutters (16, 16') in the area of contact with the blade (1) are equipped with an adjustment screw (18) useful to vary the activation time of the same shutters and consequently also of the bending and of the operating frequency of the blade (1).

10. The device according to claim 1,
**characterized in that** the shutters (116, 116') are produced with sliders (21, 21') sliding inside seats (20, 20') obtained on the fixed supports (114, 115) and equipped with milled inclined profiles (22, 22') that are engaged by the free end (123, 123') of blades (23, 23') loaded in extension by specific springs (26, 26') and equipped with slots (28, 28') that with the device at rest are aligned with the fixed magnets (12, 13) allowing the passage of their magnetic fields, all produced so that when the blade (1) bends to compress the sliders (21, 21') inside the seats (20, 20'), the inclined profile (22, 22') thereof, pushing the blades (23, 23') backward, takes the slot (28, 28') out of alignment with the respective magnet thereby causing interruption of the magnetic field.

11. The device according to claim 1,
**characterized in that** the flexible blade (1) produced with synthetic materials such as polyamide resins, carbon fibre, thermosetting resins such as epoxy resins, acrylic resins, PE, PET or the like.

12. The device according to claim 1,
**characterized in that** the flexible blade (1) is a metal blade such as stainless steel, harmonic steel, aluminium, brass and the like.

13. A system for the production of electricity comprising several modules (M) electrically connected to one another and each equipped with a plurality of devices (D) according to any of claims 1-12 connected electrically in series or in parallel, this system being installable for example on building facades, in road and rail tunnels, and also in combination with or in place of sound absorption barriers placed to protect residential areas from noise pollution.

## Patentansprüche

1. Eine Vorrichtung zur Erzeugung von Elektrizität unter Verwendung der kombinierten Wirkung von gepulsten magnetischen Feldern und fluiddynamischen Strömen, welche einen Steg (1) umfasst, der mit einem beliebigen, geeigneten flexiblen Material hergestellt wird und an einem Ende in einem Rahmen befestigt ist, wobei der genannte Steg mit einem piezoelektrischen Element (2) versehen und mit einem Magneten (11) ausgerüstet ist, dessen entgegengesetzte Pole jeweils in einem korrekten Abstand mit entsprechenden Polen weiterer Magneten (12, 13) ausgerichtet sind, welche wiederum jeweils an festen Halterungen (14, 15, 114, 115) angebracht werden, die ebenfalls entsprechende Klappen (16, 16', 116, 116') tragen, welche alle so beschaffen sind, dass in Ermangelung fluiddynamischer Ströme (V) die magnetischen Felder der oben erwähnten drei Magneten nicht miteinander interagieren, während bei Vorhandensein fluiddynamischer Ströme (V) das magnetische Feld seines jeweiligen Magneten (11), sobald der Steg (1) sich in eine Richtung biegt, bei Bewegung in Richtung des magnetischen Felds eines der genannten festen Magneten (12, 13) dessen Einfluss unterliegt und die Biegung des Steges verstärkt, bis zur Aktivierung einer Klappe (16, 16', 116, 116'), welche durch den Steg selbst betätigt wird, um den gegenseitigen Einfluss dieser magnetischer Felder durch die Einführung eines Abschnitts (217) zur Unterbrechung der magnetischen Felder an einem freien Ende der Klappe zwischen den Magneten (12, 13) zu unterbrechen, wobei der Abschnitt (217) jeweils in Aus-Stellung seitlich zu den Magneten (12, 13) angeordnet ist, wodurch der Steg selbst in die Lage versetzt wird, sich in die entgegengesetzte Richtung zu biegen, dank deren angesammelter mechanischer Energie und des Vorhandenseins der fluiddynamischen Ströme, und wodurch das piezoelektrische Element Elektrizität abgeben kann.

2. Die Vorrichtung gemäß Anspruch 1, **dadurch gekennzeichnet, dass** die Magneten (12, 13) an dem Rahmen in rechtwinkliger Stellung in Bezug auf den Magneten (11) des Steges (1) und in einer seitlichen oder frontalen Stellung in Bezug auf das freie Ende des Steges selbst befestigt sind, wobei der Steg selbst während ihrer Biegung den gegenseitigen Einfluss zwischen dem magnetischen Feld ihres Magneten (11) und dem magnetischen Feld des anliegenden Magneten (12, 13) unterbricht.

3. Die Vorrichtung gemäß Anspruch 1, **dadurch gekennzeichnet, dass** die festen Magneten (12, 13) untereinander jeweils die gleiche magnetische Kraft aufweisen, welche vorzugsweise stärker als die des Magneten (11) des flexiblen Steges (1) ist.

4. Die Vorrichtung gemäß Anspruch 1, **dadurch gekennzeichnet, dass** beide, der Magnet (11) des Steges (1) und die beiden festen Magneten (12, 13) mit den in die gleiche Richtung gerichteten Polungen montiert sind, so dass die entgegengesetzten Pole von zwei anliegenden Magneten jeweils immer mit entgegengesetztem Zeichen (N-S) oder (S-N) polarisiert sind.

5. Die Vorrichtung gemäß Anspruch 1, **dadurch gekennzeichnet, dass** die Magneten (11, 12 und 13) an dem Steg (1) und an den festen Halterungen angebracht sind, so dass die entgegengesetzten Pole von zwei anliegenden Magneten immer jeweils mit den gleichen Zeichen (N-N) oder (S-S) polarisiert sind.

6. Die Vorrichtung gemäß Anspruch 1, **dadurch gekennzeichnet, dass** ein Element (19), das mit eisenhaltigem Material hergestellt wird, an dem Steg (1) montiert ist.

7. Die Vorrichtung gemäß Anspruch 1, wobei die Klappen (16, 16') mit einem flexiblen Steg (17) hergestellt werden, der aus einem nicht magnetisierbaren Kunststoffmaterial hergestellt wird, wie Acryl, PET, PP, PVC und ähnliche.

8. Die Vorrichtung gemäß den Ansprüchen 1 und 6, **dadurch gekennzeichnet, dass** die Klappen (16, 16') mit Stegen aus einem nicht magnetisierbaren metallischen Material hergestellt werden, wie harmonischer Stahl, Edelstahl, Messing und ähnliche.

9. Die Vorrichtung gemäß einem oder mehreren der vorausgegangenen Ansprüche, **dadurch gekennzeichnet, dass** die Klappen (16, 16') im Kontaktbereich mit dem Steg (1) jeweils mit einer Stellschraube (18) ausgerüstet sind, welche dazu dient, die Aktivierungszeit der Klappen selbst und dementsprechend auch der Biegung und der Betriebsfrequenz des Steges (1) zu variieren.

10. Die Vorrichtung gemäß Anspruch 1, **dadurch gekennzeichnet, dass** die Klappen (116, 116') mit entsprechenden Schiebern (21, 21') hergestellt werden, welche im Inneren von entsprechenden Sitzen (20, 20') gleiten, die auf den festen Halterungen (114, 115) ausgeführt sind und mit gefrästen geneigten Profilen (22, 22') ausgerüstet sind, die durch das freie Ende (123, 123') von Stegen (23, 23') eingekuppelt werden, welche in der Dehnung durch spezielle Federn (26, 26') gespannt werden und mit entsprechenden Schlitzen (28, 28') ausgerüstet sind, die bei der Vorrichtung in Ruhestellung mit den festen Magneten (12, 13) ausgerichtet sind, wodurch der Durchlass ihrer magnetischen Felder gestattet wird, und zwar derart, dass wenn der Steg (1) sich biegt, um die Schieber (21, 21') im Innern der Sitze (20, 20') zu komprimieren, deren geneigtes Profil (22, 22') den Schlitz (28, 28') durch Zurückschieben der Stege (23, 23') aus der Ausrichtung mit dem entsprechenden Magneten versetzt und auf diese Weise die Unterbrechung des magnetischen Felds verursacht.

11. Die Vorrichtung gemäß Anspruch 1, **dadurch gekennzeichnet, dass** der flexible Steg (1) aus synthetischem Material wie Polyamidharze, Kohlefaser, thermoplastische Harze wie Epoxydharze, Acrylharze, PE, PET oder ähnlichen hergestellt wird.

12. Die Vorrichtung gemäß Anspruch 1, **dadurch gekennzeichnet, dass** der flexible Steg (1) ein Steg aus Metall wie Edelstahl, harmonischer Stahl, Aluminium, Messing und ähnliche ist.

13. Ein System für die Erzeugung von Elektrizität, das verschiedene Module (M) umfasst, welche jeweils elektrisch miteinander verbunden sind und wobei jedes mit einer Vielzahl von Vorrichtungen (D) gemäß einem beliebigen der Ansprüche von 1 bis 12 ausgerüstet ist, die elektrisch reihen- oder parallelgeschaltet sind und zum Beispiel an Gebäudefassaden, in Straßen- und Bahntunneln und auch in Kombination mit oder anstelle von Schallschutzwänden, welche Wohngebiete vor Lärmbelästigung schützen, installiert werden können.

## Revendications

1. Dispositif permettant de produire de l'électricité au moyen de l'action combinée de champs magnétiques pulsés et de courants dynamiques de fluides comprenant une lame (1) réalisée avec un quelconque matériau souple approprié, fixée au niveau d'une extrémité à l'intérieur d'un cadre, ladite lame étant pourvue d'un élément piézoélectrique (2) et équipée d'un aimant (11) dont les pôles opposés sont alignés à une distance correcte par rapport aux pôles respectifs d'aimants supplémentaires (12, 13) appliqués à des supports fixes (14, 15, 114, 115) qui portent également des obturateurs respectifs (16, 16', 116, 116'), tous réalisés pour qu'en l'absence de courants dynamiques de fluides (V) les champs magnétiques desdits trois aimants n'interagissent pas les uns avec les autres, tandis qu'en présence de courants dynamiques de fluides (V), des que la lame (1) se plie dans une direction, le champ magnétique de son aimant (11), se déplaçant vers le champ magnétique de l'un desdits aimants fixes (12, 13), est sujet à l'influence de celui-ci, amplifiant le pliage de la lame, jusqu'à l'activation d'un obturateur (16, 16', 116, 116') actionné par la même lame pour interrompre l'influence mutuelle de ces champs magnétiques en introduisant une partie d'interruption de champs magnétiques (217) au niveau d'une extrémité libre de l'obturateur entre les aimants (12, 13), laquelle partie (217), dans un état de repos, est positionnée latéralement aux aimants (12, 13), permettant à la même lame de se plier dans la direction opposée en raison à la fois de l'énergie mécanique accumulée de celle-ci et de la présence de courants dynamiques de fluides et permettant à l'élément piézoélectrique de libérer de l'électricité.

2. Dispositif selon la revendication 1,
**caractérisé en ce que** les aimants (12, 13) sont fixés au cadre dans une position orthogonale par rapport à l'aimant (11) de la lame (1) et dans une position latérale ou frontale par rapport à l'extrémité libre de la même lame, la même lame, pendant le pliage de celle-ci, interrompant l'influence mutuelle entre le champ magnétique de son aimant (11) et le champ magnétique de l'aimant adjacent (12, 13).

3. Dispositif selon la revendication 1,
**caractérisé en ce que** les aimants fixes (12, 13) ont une force magnétique identique les uns aux autres et de préférence supérieure à celle de l'aimant (11) de la lame souple (1).

4. Dispositif selon la revendication 1,
**caractérisé en ce que** l'aimant (11) de la lame (1) et les deux aimants fixes (12, 13) sont installés avec les polarités orientées dans la même direction, de manière à ce que les pôles opposés de deux aimants adjacents soient toujours polarisés avec un signe opposé (N-S) ou (S-N).

5. Dispositif selon la revendication 1,
**caractérisé en ce que** les aimants (11, 12 et 13) sont appliqués à la lame (1) et aux supports fixes de manière à ce que les pôles opposés de deux aimants adjacents soient toujours polarisés avec le même signe (N-N) ou (S-S).

6. Dispositif selon la revendication 1, **caractérisé en ce qu'**un élément (19) réalisé avec un matériau ferreux est monté sur la lame (1).

7. Dispositif selon la revendication 1,
où les obturateurs (16, 16') sont réalisés avec une lame souple (17) composée d'un matériau plastique non magnétisable, comme des acryliques, PET, PP, PVC et similaires.

8. Dispositif selon les revendications 1 et 6 **caractérisé en ce que** les obturateurs (16, 16') sont réalisés avec des lames composées d'un matériau métallique non magnétisable, comme de l'acier harmonique, de l'acier inoxydable, du laiton et similaires.

9. Dispositif selon l'une ou plusieurs des revendications précédentes, **caractérisé en ce que** les obturateurs (16, 16') dans la zone de contact avec la lame (1) sont équipés d'une vis de réglage (18) utile pour varier le temps d'activation des mêmes obturateurs et par conséquent également du pliage et de la fréquence de fonctionnement de la lame (1).

10. Dispositif selon la revendication 1,
**caractérisé en ce que** les obturateurs (116, 116') sont réalisés avec des éléments coulissants (21, 21') qui coulissent à l'intérieur des sièges (20, 20') obtenus sur les supports fixes (114, 115) et équipés de profils inclinés fraisés (22, 22') qui sont engagés par l'extrémité libre (123, 123') des lames (23, 23') chargées en extension par des ressorts spécifiques (26, 26') et équipées de fentes (28, 28') qui avec le dispositif au repos sont alignées avec les aimants fixes (12, 13) permettant le passage de leurs champs magnétiques, tous réalisés pour que lorsque la lame (1) se plie pour comprimer les éléments de coulissement (21, 21') à l'intérieur des sièges (20, 20'), le profil incliné (22, 22') de ceux-ci, poussant les lames (23, 23') vers l'arrière, retire la fente (28,28') de l'alignement par rapport à l'aimant respectif provoquant ainsi une interruption du champ magnétique.

11. Dispositif selon la revendication 1,
**caractérisé en ce que** la lame souple (1) est réalisée en matériaux synthétiques comme des résines polyamides, des fibres de carbone, des résines thermodurcissables comme des résines époxy, des résines acryliques, PE, PET ou similaires.

12. Dispositif selon la revendication 1,
**caractérisé en ce que** la lame souple (1) est une lame métallique comme de l'acier inoxydable, de l'acier harmonique, de l'aluminium, du laiton et similaires.

13. Système permettant de produire de l'électricité comprenant plusieurs modules (M) connectés électriquement les uns aux autres et chacun équipé d'une pluralité de dispositifs (D) selon l'une quelconque des revendications 1 à 12 connectés électriquement en série ou en parallèle, ce système pouvant être installé par exemple sur des façades de bâtiments, sur des routes et des tunnels ferroviaires, et également en combinaison avec ou à la place de barrières d'absorption acoustique placées pour protéger des zones résidentielles de la pollution sonore.
